# EUROPÄISCHE PATENTSCHRIFT

(11) **EP 0 231 164 B1**
(45) Veröffentlichungstag und Bekanntmachung des Hinweises auf die Patenterteilung: **06.04.1994**
(21) Anmeldenummer: 87890020.8
(22) Anmeldetag: 30.01.1987
(51) Int. Cl.: H01J 37/30, H01J 37/317

(54) **Einrichtung für Ionenprojektionsgeräte**
Device for ion-projection apparatuses
Dispositif pour appareils de projection ionique

(30) Priorität: 31.01.1986 AT 237/86
(43) Veröffentlichungstag der Anmeldung: 05.08.1987
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Löschner, Hans, Dr., A-1190 Wien (AT); Stengl, Gerhard, Dr., A-9500 Villach (AT); Wolf, Peter, Dr., A-1060 Wien (AT)
(74) Vertreter: Matschnig, Franz, Dipl.-Ing.

(56) Entgegenhaltungen:
- FR-A- 2 513 398
- US-A- 4 514 638
- JOURNAL OF VACUUM SCIENCE & TECHNOLOGY/B, Band 3, Nr. 1, Zweite Serie, Januar-Februar 1985, Seiten 106-111, American Vacuum Society; H.J. KING et al.: "An electron beam lithography system for submicron VHSIC device fabrication"
- PATENT ABSTRACTS OF JAPAN, Band 7, Nr. 170 (E-189)[1315], 27. Juli 1983 ; & JP-A-58 75 746 (TOKYO SHIBAURA DENKI K.K.) 07-05-1983
- PATENT ABSTRACTS OF JAPAN, Band 9, Nr. 39 (E-297)[1762], 19. Februar 1985 ; & JP-A-59 181 019 (FUJITSU K.K.) 15-10-1984
- SOLID STATE TECHNOLOGY, August 1982, Seiten 104-109; G. STENGL et al.: "Ion projection microlithography"
- EXTENDED ABSTRACTS OF THE 18th (1986 INTERNATIONAL) CONFERENCE ON SOLID STATE DEVICES AND MATERIALS, Tokyo, 20.-22. August 1986, Seiten 29-32, Business Center for Academic Soc. Japan, Tokyo, JP; G. STENGL et al.: "Sub-0. 1-mum ion projection lithography"

## Beschreibung

Bei Projektionssystemen, bei welchen mittels elektrisch geladener Teilchen, beispielsweise Ionen, die Struktur einer Maske auf ein Substrat abgebildet wird, bestehen hinsichtlich der zu fordernden Überdeckungsgenauigkeit bei der Anwendung mehrerer Masken, die nacheinander auf das gleiche Substrat abgebildet werden sollen, hohe Anforderungen. In Solid State Technology, Aug. 82, Seiten 104 - 109; G. Stengl et al.: "Ion projection microlithography" wird ein Zweistufenverfahren zur Erzielung der Überdeckung vorgeschlagen. In der ersten Stufe wird hiebei mechanisch mittels eines Koordinatentisches eine grobe Ausrichtung mit einer Genauigkeit von ca. 1 µm erreicht. Auf die grobe (mechanische) Ausrichtung folgt eine Fein-Ausrichtung mit einer Genauigkeit von +/- 0,05 µm durch elektrostatische Ablenkung des Ionenbildes in x- und y-Richtung und eine Drehung des Bildes durch Anwendung eines axialen Magnetfeldes. Die Feinausrichtung erfolgt dabei, ohne daß Körper bewegt werden. Der Abbildungsmaßstab kann durch Ändern der Spannung an den Linsen des Projektionssystems geändert werden.

Herstellungsbedingte Fehler in den abzubildenden Strukturen der Masken können Ursache dafür sein, daß etwa Strukturen entlang einer geraden Linie in der Maske nicht in einer geraden, sondern in einer gekrümmten Linie vorhanden sind. Es besteht daher ein Bedarf, derartige Unvollkommenheiten beim Projektionsvorgang zu eliminieren.

Ausgangspunkt für jede Korrektur sind dabei die Istdaten der Strukturen, die von der jeweiligen Maske genommen werden. Aufgrund dieser Istdaten kann dann die Korrektur durch Änderungen im Projektionssystem ausgeführt werden.

Bekannt wurde bereits ein Elektronenschattenbelichtungssystem, bei dem von einer Elektronenquelle ein divergenter Strahl abgegeben wird, der auf eine hexagonale Öffnung gerichtet wird. Mittels einer Kollimatorlinse, welche die Öffnung umschließt, wird ein parelleler Strahl erzeugt, der sich längs der Achse der optischen Säule ausbreitet. In einem sogenannten Ablenkungsabschnitt sind zwei Ablenkungssysteme vorgesehen. Mittels des ersten Systemes wird der Strahl parallel zur Säulenachse quer über die Maskenfläche gescannt. Mittels des zweiten Systems kann der Strahl um einen Schwenkpunkt in der Maskenebene gekippt werden, sodaß er unter einem von 90° abweichenden Winkel auf die Maske auftrifft, sodaß das Bild der Maskenöffnung oder einzelne Kanten des Bildes verschoben werden können. Damit kann also das Bild auf dem Substrat um kleine Beträge durch die Kippung der Richtung des Strahles verschoben werden. Wendet man eine konstante Kippung des Strahles an, so ist es möglich, das gesamte Maskenbild auf dem Substrat zu verschieben. Dadurch können Positionsabweichungen desTisches kompensiert werden. Ändert man leicht die Kippung des Strahles während des Scannvorganges, so ist es möglich, eine geringfügige Drehung des Bildes zu erreichen, um durch Tischschwankungen verursachte Fehler zu kompensieren. Die bekannte Einrichtung ermöglicht es, durch entsprechende Kippung des Strahles das Bild in nichtlinearer Weise während der Schattenbelichtung zu verändern und auf diese Weise vorhandene Maskenverzerrungen bei der Substratbelichtung zu kompensieren.

Bekannt wurde auch, im Strahlengang einer korpuskularoptischen Abbildungseinrichtung einen Multipol anzuordnen (DD-PS 22 04 52). Dieser Multipol bietet nur zwei Möglichkeiten, unterschiedliche Spannungen anzulegen. Zweck des bekannten Multipoles ist es, Abbildungsfehler einer rotationssymmetrischen Linse zu minimieren.

Bei einer weiteren bekannten elektronen- bzw. ionenoptischen Projektionseinrichtung (FR-A 25 13 398) werden Multipole zur Kompensation des astigmatischen Linsenfehlers angewendet. Eine solche Einrichtung kann auch steuerbare Korrekturelemente zur Verschiebung des von der Maskenstruktur erzeugten Bildes aufweisen. Der astigmatische Linsenfehler wird durch die Abweichung der Linsenfelder von idealer Rotationssymmetrie hervorgerufen, welche normalerweise auf Fertigungsungenauigkeiten beruht. Wenn dieser Astigmatismus in der Umgebung des Gegenstandes, also der Maske, auftritt, bewirkt er Verzerrungen des Bildes. Tritt er dahinter auf, so führt dies zu unterschiedlichen Brennebenen in x- und in y-Richtung und verursacht Unschärfe am Bildort. Die in der bekannten Einrichtung verwendeten Multipole werden genauso angesteuert, daß - quer zum Strahl - in einer Richtung ein bestimmtes positives Feld erzeugt wird und in der dazu senkrechten Richtung ein negatives Feld gleichen Betrages entsteht. Dies entspricht einem Quadrupolfeld mit den Potentialwerden +Uo, -Uo, +Uo, -Uo (bzw. magnet. Feldwerten +H1, -H1, +H1, -H1). Falls der Quadrupol nicht mechanisch drehbar ist, so wird in dem genannten Dokument vorgeschlagen, einen zweiten, um 45° gedrehten Quadrupol einzuführen, mit dem die Feldverteilung dann elektromagnetisch drehbar wird. Dabei handelt es sich dann um einen Oktopol mit vier verschiedenen Potential-(Feld-)Werten, nämlich +H1cosδ, -H1cosδ, +H1sinδ, -H1sinδ. Diese Potentiale sind zwingend voneinander abhängig und bewirken wieder genau ein Quadrupolfeld, das jedoch um den Winkel δ/2 zur festen y-Achse gedreht ist.

Durch die DE-OS 30 10 815 und die DE-OS 33 45 573 wurden Einrichtungen zur Verbesserung der Formierung von Teilchenbündeln, nämlich insbesondere zur Steuerung des Cross-over-Bereiches der Teilchen, bekannt. In beiden Fällen befindet sich das Korrekturelement unmittelbar nach der Quelle bzw. bildet es einen Teil der Quelle.

Das Dokument Extended Abstracts of the 18th (1986 International) Conference on Solid State Devices and Materials (20.-22. August 1986), Tokyo, 1986, Seiten 29-32, Business Center for Academic Soc. Japan, Tokyo, JP; G. STENGL et al.: "Sub-0.1-µm Ion Projection Lithography" als Zwischenliteratur, enthält einen Hinweis, auf elektronischem Weg Feldverzerrungen zu korrigieren. Danach soll ein elektrischer und magnetischer Multipol zwischen der Maske und einer im Strahlengang auf die Maske folgenden Immersionslinse angeordnet werden, um den Ionenstrom durch das ionenoptische System zu beeinflussen und Korrektur oder Justierung einer Vielzahl von unterschiedlichen Verzerrungsmustern vorzunehmen.

Der Erfindung liegt die Aufgabe zugrunde, mittels einer möglichst einfach aufgebauten Vorrichtung Korrekturen des Bildes bzw. Änderungen des Bildes von Maskenstrukturen vorzunehmen.

Die Erfindung geht dabei aus von einer Einrichtung für Projektionsgeräte für elektrisch geladene Teilchen, insbesondere Ionen, zum Ändern des auf einem Substrat erzeugten Bildes einer im Strahlengang des Projektionsgerätes befindlichen Struktur einer Maske, wobei im Strahlengang zwischen der Maske und dem Substrat ein ionen- bzw. elektronenoptisches Linsensystem mit einem steuerbaren Korrekturelement angeordnet ist, das nach der Maske auf den Strahl aus elektrisch geladenen Teilchen einwirkt, und erreicht hiebei das vorerwähnte Ziel, wenn gemäß der Erfindung zur gezielten Verformung des Bildes der Struktur der Maske das Korrekturelement mit einstellbarer Feldverteilung mindestens vier, bevorzugt jedoch über hundert ansteuerbare elektrische und/oder magnetische Pole aufweist, wobei jeder einzelne Pol unabhängig von den anderen angesteuert werden kann, also z.B. alle vier Pole eines elektrostatischen Quadrupols mit verschiedenen Potentialen belegt werden können, und die Projektionseigenschaften des gesamten nach der Maske vorhandenen Strahlenbündels in verschiedenen Teilgebieten unterschiedlich veränderbar sind. Das in erfindungsgemäßer Weise vorgesehene steuerbare Korrekturelement mit einstellbarer Feldverteilung erlaubt es, die von den reellen Strukturen auf der Maske ausgehenden Teilbündel so zu verändern, daß sie von den gewünschten, virtuellen Strukturen der Maske auszugehen scheinen, weil die Projektionseigenschaften des gesamten nach der Maske vorhandenen Strahlenbündels in verschiedenen Teilgebieten unterschiedlich verändert werden können. Durch entsprechende Ausgestaltung der Pole ist es möglich, die auftretenden Verzerrungen, beispielsweise Anamorphismus oder einen Kissen- oder tonnenförmigen, einschließlich einen einseitig kissenförmigen, trapezoidischen, rhomboidischen Verlauf zu korrigieren bzw. einzustellen.

Damit können, ausgehend von Kissen- oder tonnenförmigen Verzerrungen der Maskenstrukturen, unverzerrte Bilder hergestellt werden.

Im Gegensatz zum Bekannten, nämlich dem vorerwähnten Elektronenschattenbelichtungssystem, wird durch Anwendung der erfindungsgemäßen Maßnahme eine statische Korrektur erzielt, wobei die einmal justierte Linse, deren Justierung einer bestimmten Maske und/oder einer bestimmten ionen- oder elektronenoptischen Anordnung angepaßt ist, beibehalten werden kann. Mit der bekannten Einrichtung hingegen ist eine dynamische Verzerrungskorrektur erforderlich, da während des Scannens der Maske der Strahl jeweils geeignet gekippt werden muß.

Auch bei Anwendung der erfindungsgemäßen Einrichtung ist es möglich, linsenbedingte Verzerrungen des projizierten Bildes der Maskenstrukturen, z.B. fertigungsbedingte Fehler der Linsen, zu kompensieren, d.h. es können bestimmte, in situ vorhandene Fehler bereits bei der Programmierung der Feldverteilung berücksichtigt werden. Es ist damit also möglich, nicht nur Maskenfehler zu kompensieren, sondern auch Fehler der ionen- bzw. elektronenoptischen Säule zu korrigieren.

Eine statische Korrekturmaßnahme ist aus der DD-PS 220 452 bereits bekannt. Hiebei wird ein elektrostatischer Multipol dazu verwendet, entweder allein oder zusätzlich zu einem vorhandenen Linsensystem die geometrischen Aberrationen bei der Abbildung zu minimieren. Der bekannte Multipol besteht aus einem Rohr kreisförmigen Querschnitts mit zwei oder mehr Durchbrüchen, welche durch metallische Deckel, elektrisch vom Rohr isoliert, abgeschlossen sind. An das Rohr und an die Deckel können verschiedene Potentiale angelegt werden, wobei alle Deckel auf demselben Potential liegen. Ein solcher Multipol kann also insgesamt immer nur mit zwei verschiedenen Potentialwerten angesteuert werden. Darüberhinaus kann auch bei nichtverzerrten Masken mittels der erfindungsgemäßen Einrichtung ein gewünschtes Verzerrungsmuster am Substrat eingestellt werden.

Häufig sind in der Projektion von integrierten Schaltungen optische Lithographiegeräte, z. B. optische Waferstepper, eingesetzt, mit welchen in aufeinanderfolgenden Schritten Strukturen von verschiedenen Masken auf einen Chip projiziert werden. Diese Waferstepper sind jedoch untereinander nicht kompatibel, insbesondere wenn besonders kleine, verschiedenen Maskenebenen entsprechende Strukturen mit über das Chipfeld genügend genauer Überdeckung abgebildet werden müssen.

Bei Anwendung der erfindungsgemäßen Einrichtung jedoch ist es möglich, das ionen- bzw. elektronenoptische Projektionsgerät kompatibel zu bestehenden lichtoptischen oder Röntgenlithographiegeräten zu verwenden.

In weiterer Ausgestaltung der Erfindung wird das Korrekturelement mit einstellbarer Feldverteilung unmittelbar nach der Maske im Strahlengang angeordnet. Diese Maßnahme erlaubt es, die erforderlichen Korrekturen besonders einfach auszuführen und zu beherrschen.

Die Erfindung wird nachstehend anhand der Zeichnungen beispielsweise näher erläutert. Hiebei zeigt
Fig. 1 schaubildlich zwei Chip-Bereiche auf einem Substrat, wobei Maskenstrukturen über ein Step- und Repeatverfahren abgebildet sind.
Fig. 2 veranschaulicht ein Detail A aus Fig. 1,
Fig. 3 schematisch ein mit der erfindungsgemäßen Einrichtung ausgestattetes Projektionsgerät,
Fig. 4 ein Schema zur Erläuterung des durch die erfindungsgemäße Einrichtung erreichbaren Effektes, und
Fig. 5 die Vorgänge bei der Änderung des Verlaufes des Randes einer Abbildung unter Anwendung der erfindungsgemäßen Einrichtung.

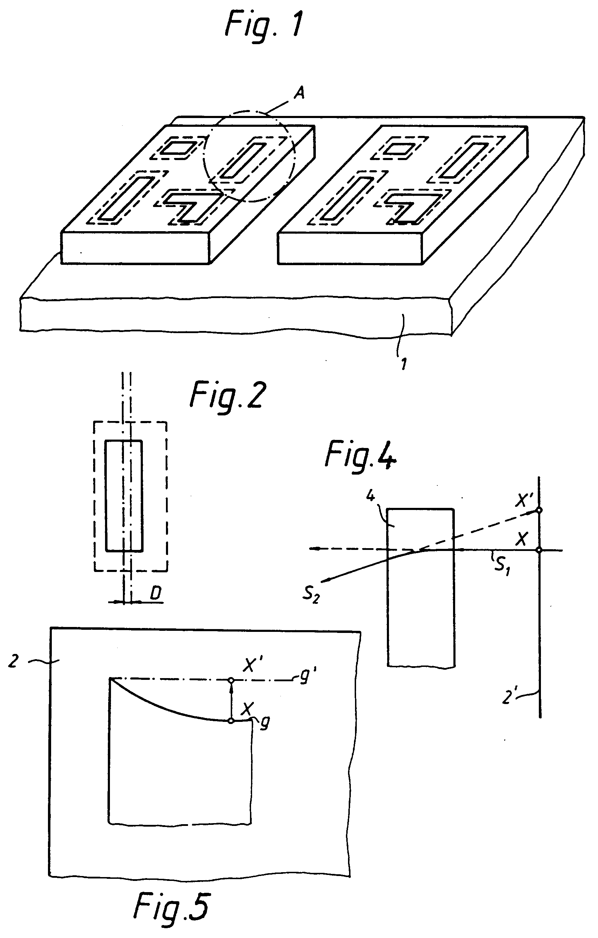

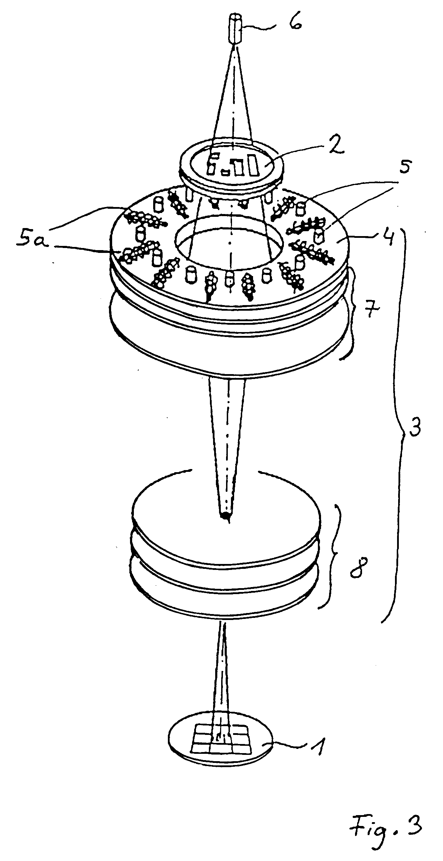

In Fig. 1 ist mit 1 ein Substrat dargestellt, auf welches,z.B. durch Ionenprojektionslithographie, Maskenstrukturen verkleinert abgebildet werden. Das Bild der ersten Maske, die durch einen ersten Beschuß auf das Substrat 1 abgebildet wird, ist dabei in unterbrochenen Linien gezeichnet. Nach der Generierung des ersten Bildes wird auf das Substrat 1 unter Verwendung einer zweiten Maske ein zweites Bild erzeugt, welches in durchgehenden Linien dargestellt ist. Dabei ist im in Fig. 1 linken Chip der Fall dargestellt, daß alle Strukturen, ausgenommen jene in der rechten oberen Ecke, ideal überdeckt sind, so daß eine einseitig trapezförmige Verzeichnung der Abbildung der zweiten gegenüber der ersten vorliegt. Im rechten Chip der Fig. 1 ist die Auswirkung der Erfindung dargestellt, wo auch in der rechten oberen Ecke die ideale Überdeckung erreicht ist.

In Fig. 2 ist das mit A bezeichnete Detail aus Fig.1 wiedergegeben, und es ist ersichtlich, daß die Längssymmetrielinien der beiden in aufeinanderfolgenden Schritten abgebildeten Rechtecke sich um den Betrag D unterscheiden. Dieser Betrag D soll mit hoher statistischer Zuverlässigkeit kleiner sein als 1/5 bis 1/10 der minimalen Linienbreite des integrierten Schaltkreises, insbes. bei den mit Ionenprojektionslithographie möglichen minimalen Linienbreiten von 0,2 bis 0,3 µm. Daraus erhellt die große Genauigkeit, die erforderlich wird, um die geforderte Überdeckungsgenauigkeit auch über den gesamten Chipbereich zu erreichen.

Aus Fig. 3 ist schematisch die erfindungsgemäße Einrichtung für ein Ionenprojektionsgerät ersichtlich. Dieses Gerät besitzt eine Ionenquelle 6. Im Strahlengang der von der Ionenquelle emittierten Ionen befindet sich die Maske 2 und ein hinter dieser Maske angeordnetes ionenoptisches Linsensystem 3. Die aus dem ionenoptischen Linsensystem 3 austretenden Ionenstrahlen gelangen auf das Substrat 1. Das ionenoptische Linsensystem kann in bekannter Weise eine Imersionslinse 7 und eine Projektionslinse 8 umfassen. In neuartiger Weise ist unmittelbar hinter der Maske 2 ein Ausführungsbeispiel des beschriebenen, erfindungsgemäßen Korrekturelementes 4 mit der erwähnten einstellbaren Feldverteilung angeordnet. Das Korrekturelement 4 mit einstellbarer Feldverteilung kann dabei kreiszylindrische Elektroden 5 und magnetische Pole 5a aufweisen. Die Pole 5 und 5a können mit jeweils unterschiedlichen Potentialen bzw. Spulenströmen gespeist werden und lenken Ionen- bzw. Elektronenstrahlenteilbündel, die den Maskenstrukturen entsprechen, unterschiedlich ab.

In Fig. 4 ist die Maskenebene mit 2′ bezeichnet. Ein durch den Punkt X der Maske verlaufender Ionen-bzw. Elektronenstrahl S₁ wird durch das Korrekturelement 4 abgelenkt und tritt als Strahl S₂ aus. Dieser Strahl entspricht somit dem virtuellen Punkt X′ in der Maskenebene 2′. Durch Anwendung des Korrekturelementes 4 gelingt es daher, vom Punkt X ein Bild auf dem Substrat zu erzeugen, welcher anstatt von Punkt X vom virtuellen Punkt X′ stammt. Nimmt man nun an, daß der Punkt X ein Punkt einer krummlinigen Berandung der Maske ist und die Maske im Idealfall eine geradlinige Berandung aufweisen sollte, so kann,bei Anwendung des Korrekturelementes 4,vom Punkt X ein Bildpunkt erzeugt werden, so als ob der Punkt X′ abgebildet worden wäre. Da X′ auf der virtuellen Geraden g′ gelegen ist, wird im Bild die Gerade g′ abgebildet und damit der Maskenfehler, der dadurch entstehen würde, daß die Maske statt der geradlinigen Berandung g′ eine krummlinige Berandung g aufweist, kompensiert (Fig.5).

## Patentansprüche

1. Einrichtung für Projektionsgeräte für elektrisch geladene Teilchen, insbesondere Ionen, zum Ändern des auf einem Substrat erzeugten Bildes einer im Strahlengang des Projektionsgerätes befindlichen Struktur einer Maske, wobei im Strahlengang zwischen der Maske und dem Substrat ein ionen- bzw. elektronenoptisches Linsensystem mit einem steuerbaren Korrekturelement angeordnet ist, das nach der Maske auf den Strahl aus elektrisch geladenen Teilchen einwirkt, dadurch gekennzeichnet, daß zur gezielten Verformung des Bildes der Struktur der Maske das Korrekturelement (4) mit einstellbarer Feldverteilung mindestens vier, bevorzugt jedoch über hundert ansteuerbare elektrische und/oder magnetische Pole (5) aufweist, wobei jeder einzelne Pol unabhängig von den anderen angesteuert werden kann, also z.B. alle vier Pole eines elektrostatischen Quadrupols mit verschiedenen Potentialen belegt werden können, und die Projektionseigenschaften des gesamten nach der Maske vorhandenen Strahlenbündels in verschiedenen Teilgebieten unterschiedlich veränderbar sind.

2. Einrichtung nach Anspruch 1, dadurch gekennzeichnet, daß das Korrekturelement (4) mit einstellbarer Feldverteilung unmittelbar nach der Maske (2) im Strahlengang angeordnet ist.

## Claims

1. Apparatus for projection devices for electrically charged particles, particularly ions, for altering the image produced on a substrate of a structure of a mask disposed in the beam path of the projection device, whereby an ion or electron-optical lens system with a controllable correction element is arranged in the beam path between the mask and the substrate which acts on the beam of electrically charged particles behind the mask, characterised in that in order to deliberately distort the image of the structure of the mask the correction element (4) with adjustable field distribution has at least four, but preferably more than one hundred, controllable electrical and/or magnetic poles (5), whereby each individual pole can be controlled independently of the others, that is to say different potentials can be applied to e.g. all four poles of an electrostatic quadrupole, and the projection characteristics of the entire beam of radiation behind the mask may be altered differently in different regions.

2. Apparatus as claimed in Claim 1, characterised in that the correction element (4) with adjustable field distribution is arranged directly behind the mask (2) in the beam path.

## Revendications

1. Dispositif pour appareils de projection destinés à des particules chargées électriquement, en particulier des ions, afin de modifier l'image, produite sur un substrat, de la structure d'un masque se trouvant dans la trajectoire de rayonnement de l'appareil de projection, un système de lentilles ioniques et/ou d'optique électronique, comportant un élément de correction réglable, étant disposé dans la trajectoire de rayonnement entre le masque et le substrat et agissant, en fonction du masque, sur le rayon de particules chargées électriquement, caractérisé en ce que, pour la déformation ciblée de l'image de la structure du masque, l'élément correcteur (4) à répartition de champ réglable possède au moins quatre, mais de préférence plus de cent pôles (5) électriques et/ou magnétiques susceptibles d'être commandés, chaque pôle pouvant être commandé indépendamment des autres et, donc, par exemple, quatre pôles d'un quadripôle électrostatique pouvant être mis à des potentiels différents, et les caractéristiques de projection de l'ensemble du faisceau de rayons, présent après le masque, pouvant être modifiées dans différentes zones.

2. Dispositif selon la revendication 1, caractérisé en ce que l'élément correcteur (4) à répartition de champ réglable est disposé, dans la trajectoire de rayonnement, directement après le masque (2).
